# EUROPEAN PATENT APPLICATION

(11) **EP 0 702 235 A1**
(43) Date of publication of application: **20.03.1996**
(21) Application number: 95305394.9
(22) Date of filing: 02.08.1995
(51) Int. Cl.: G01R 13/40

(54) **Graphical trend display methods and apparatus in a test instrument**

(30) Priority: 15.09.1994 US 306549
(71) Applicant: FLUKE CORPORATION, Everett, Washington 98206-9090 (US)
(72) Inventor: Gibson, Robert T., Snohomish, Washington 98290 (US)
(74) Representative: Burke, Steven David

(57) **Abstract**

A test instrument provides a trend display mode in which the instrument presents a simplified, graphical representation of measurement data acquired over an extended period of time called a test interval. The graphic "trend display" is updated periodically at a shorter, user selectable frequency called the trend interval. The invention is disclosed in a preferred embodiment in which it is deployed in a portable test instrument similar to a digital multimeter.

## Description

### Related Application Data

This application is related to commonly-assigned U.S. application No. 08/306550 filed simultaneously herewith and entitled "Peak Current Detection in a Test Instrument for Ensuring Validity of Component Test Output."

### BACKGROUND OF THE INVENTION

### Field of the Invention

The present invention relates to electronic test instruments and related methodologies, and in particular relates to instruments such as multimeters which are used to measure voltage, current, impedance and other parameters of an electrical component or circuit. More specifically, the present invention relates to methods and apparatus for simplifying measurement data so as to form "trend" data and graphically displaying the trend data.

### Background

In known test instruments, such as a digital multimeter, measurement data or "readings" are displayed in real-time, i.e., they "track" the voltage, current or other parameter of interest as it changes, except for a relatively short delay or response time. Frequently, however, it is useful to examine test measurement data over a desired test interval, e.g. several seconds, minutes or even hours, without the need for constant observation of the instrument. Techniques are known in the prior art for recording test data over an extended period of time, for example in solid state memory or on magnetic tape. Such techniques require a substantial amount of memory or recording media, as the amount of acquired data can grow quite large. Moreover, stored data of that type must be recalled and further processed and analyzed to present it in a manner readily useful to a user. The need remains for a method of recording and presenting test data representative of an extended test interval in a simplified, graphical form for immediate use.

For many applications, exhaustive measurement data is not required or desired. For example, troubleshooting and repair of many devices, at a repair depot or in the field, can be facilitated by a test instrument that provides simplified, overview data rather than overwhelming volumes of detailed data. For example, data sampled every 10 seconds or even every 10 minutes can suffice to check operation of some apparatus. Often there is no need for the repair technician to examine every measured value. Rather, it would be useful to provide simplified "trend" data and display it to a user in graphical form. For some applications, it would be useful for graphical trend data to indicate the highest and lowest values measured over a given interval. Another useful type of trend display would indicate the average value measured over the test interval. It would also be useful to capture and graphically indicate discontinuities in the measurement data as part of a trend display.

In the prior art, test instruments such as a volt-ohm meter (VOM) are used for basic measurements such as AC and DC voltage or ohms. VOMS provide an analog meter for reading the instrument. They are difficult to read and have limited ability to store measured values. More recently, digital multimeters (DMM) provide improved accuracy and readability through digital (numeric) displays. Graphical displays, however, for displaying waveforms or triggered events, generally are available only on oscilloscopes, which are quite large, heavy, expensive and complicated to operate as compared to a simple DMM. The need remains to provide for such graphical output in a portable, low-cost test instrument for use on the benchtop or in the field by personnel with minimal training and experience.

### SUMMARY OF THE INVENTION

An object of the present invention is to record measurement data over a defined test interval, and to immediately present such data to a user in a simplified, graphical form.

Another object of the invention is to display measurement data in graphical form in a relatively simple, low-cost test instrument.

A further object of the invention is to provide measurement data in a graphical format in which measurements taken over an extended test period are reduced to a simple trend display format for fast, easy analysis by a user.

According to the present invention, a test instrument provides a trend display mode in which the instrument presents a graphical representation of data acquired over an extended period of time called a test interval. This graphic "trend data" is updated periodically at a shorter, user-selectable frequency called the "trend interval." The resulting display is called a sampled trend display. However, sampling measurement data at the trend interval may not truly represent the data over the test interval. Optionally, measurement data is averaged over each individual trend interval, and these results are graphically displayed to the user. The resulting display is called an average trend display.

For some applications, the highest and lowest measured values are of interest to the user. Another option, according to the invention, it to determine these extreme values for each trend interval, and present the results graphically as a high-low trend display. A further option is to capture discontinuities (or "glitches") throughout an impedance test interval, and to include icons in the graphical display to indicate such discontinuities in the corresponding trend interval along with the sampled, average or high-low impedance information. Trend data is displayed in a graphical display window formed on a display panel. Other information such as a numeric reading is displayed on the panel outside the graphical display window. In a preferred embodiment, various aspects of the invention are implemented in a portable test instrument otherwise similar to a DMM.

This "graphical test instrument" brings the advantages of graphic displays to the portable test equipment at low cost. The invention provides a graphical trend display that can reflect measurement data sampled at a user-selectable trend interval. The graphical trend display can reflect measurement data averaged over each one of a plurality of trend intervals. The graphical trend display can also reflect the highest and lowest measurement values for each one of a plurality of trend intervals.

The foregoing and other objects, features and advantages of the invention will become more readily apparent from the following detailed description of a preferred embodiment which proceeds with reference to the drawings.

### BRIEF DESCRIPTION OF THE DRAWINGS

FIG. 1 illustrates a portion of a front panel of a test instrument operating in a sample-type of trend display mode of operation.

FIG. 2 illustrates the instrument of FIG. 1 operating in an average-type of trend display mode of operation.

FIG. 3 illustrates the instrument of FIG. 1 operating in an average-type of trend display mode of operation with a glitch capture feature enabled.

FIG. 4 illustrates an enlarged portion of the instrument front panel of FIG. 1 showing a sample-type of trend display.

FIG. 5 illustrates an enlarged portion of the instrument front panel of FIG. 1 showing a high-low type of trend display.

FIG. 6 is a diagram illustrating operation of a microprocessor in the test instrument of FIG. 1 for processing of trend data according to the present invention.

FIGS. 7A and 7B together form a simplified block diagram of pertinent portions of the test instrument of FIG. 1.

FIG. 8 illustrates an enlarged portion of the instrument front panel of FIG. 1 showing an average-type of trend display.

### DETAILED DESCRIPTION OF THE PREFERRED EMBODIMENT

### I. USER INTERFACE

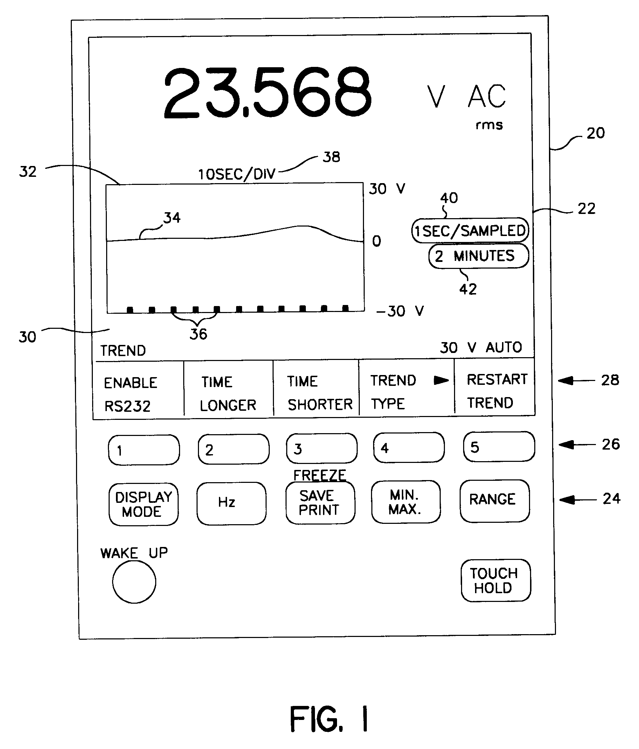

FIG. 1 shows a portion of a front panel 20 of a test instrument. The front panel includes a display 22, formed of a liquid crystal display module as further described later. The front panel also includes a plurality of push buttons or keys 24, also referred to as hard keys. These are ordinary keyswitches which are used to select or change a feature or mode of operation as indicated on the key. For example, the hard key labeled "range" may be used to select an appropriate operating range of the instrument. The left-most hard key, labeled "display mode' is used to select among several available display modes, each of which displays different combinations of information in different ways on the display 22. In this case, "trend" is the selected display mode, as indicated on the display at reference 30. A primary numerical reading is displayed in large characters near the top of display 22. In this case, the reading is 23.568 V AC. In the trend display mode, display 22 also includes a graphic display window 32 located below the primary numerical reading.

The instrument panel also includes a series of 5 "soft keys" indicated by reference 26. The soft keys (numbered 1-5 in the drawing), are actually ordinary keyswitches for selecting desired features or operating parameters. The particular function of each soft key depends upon the current state and operating mode of the instrument. The function of each soft key is displayed along the bottom of display 20 indicated generally by reference 28. Here, since the "trend" display mode has been selected, the soft keys have the functions indicated on the display, namely, "Enable RS232", "Time longer", "Time shorter", "Trend Type" and "Restart Trend" as illustrated. Soft key 1 thus enables transmission of trend data from the instrument over an RS232 port. The trend display mode is described in detail below.

Operation in the trend display mode requires the user to select a "trend interval" which defines a time interval between data samples that are retained and displayed in window 32, as further described later. The trend interval can be within any desired range. In a presently preferred embodiment, the trend interval is selectable within a range of approximately 1 second to 15 minutes. In the presently preferred commercial embodiment, the trend interval is selected from a predetermined series of choices, for example: 1 second, 2 seconds, 5 seconds, 10 seconds, 15 seconds, 30 seconds, 45 seconds, 1 minutes, 2 minutes, 5 minutes, 10 minutes and 15 minutes. The trend interval is selected by using the "Time Longer" and "Time Shorter" soft keys (soft keys 2 and 3) as appropriate. The selected trend interval is indicated on the display at reference 40 (e.g., 1 second). The graphic display window 32 includes 120 columns. Since the selected trend interval is 1 second, the total test interval, i.e., the period of time represented by the graphic display 32 is 120 seconds or 2 minutes. This test interval also is shown on the display at reference 42.

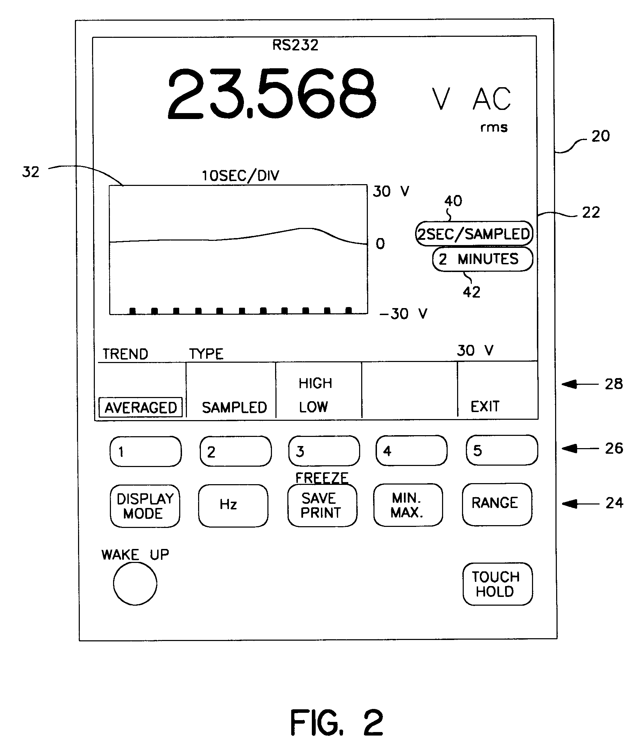

Soft key 4 is used for selecting the type of trend display. The triangular pointer in the part 28 of the display 22 that reads "Trend Type" indicates that pressing the corresponding soft key (4) will result in the display of a submenu across the bottom of the display, thereby assigning new meanings to the soft keys for selecting the type of trend display. The resulting display is shown in FIG. 2. Referring to FIG. 2, the part 28 of the display 22 shows the selected display mode, "Trend" and the name of the current submenu "Type'. The types of trend displays are *sampled, average*, and *high/low*, a desired one of which is selected by pressing the corresponding soft key 26. In the display state illustrated in FIG. 2, soft key 4 is not used and soft key 5 is used to exit from this submenu. The contents of display 22 as shown in FIG. 2 are similar to those of FIG. 1 with two exceptions. First,the RS232 communication feature is enabled in FIG. 2 as indicated at the top of the display screen. Also, the average type of trend display has been selected. This type is indicated both because the corresponding soft key label is highlighted or reversed video, and the word "Average" is shown on the screen after the virgule in area 40.

Referring again to FIG. 1, it may be observed that the "Sample" type of trend display was selected. The graphic display window 32 includes a graticule 36 along the bottom of the graphic display. Over the top of the display, the horizontal scale is shown as "10sec/DIV" or 10 seconds per division. Since there are 12 divisions in the illustration, 10 seconds per division corresponds to the total test interval of 2 minutes. Particulars of the displayed trend waveform 34 will be described later.

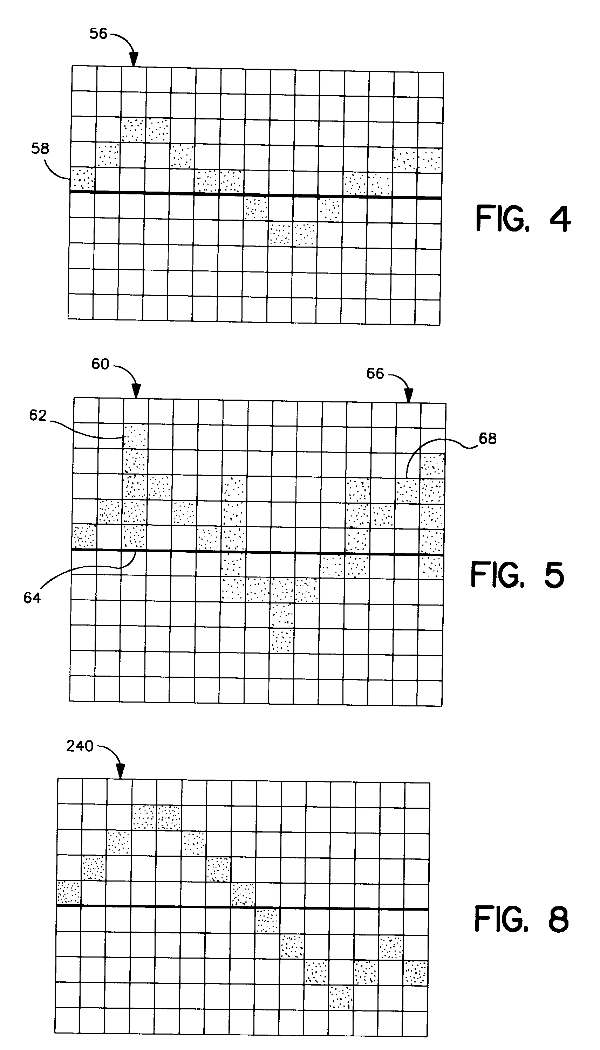

FIG. 4 is an enlarged view of a portion of a trend display waveform shown in display window 32. Each column in the illustration of FIG. 4, e.g. column 56, corresponds to one trend interval. Thus, each column represents a user-selected period of several seconds or minutes, or even hours. FIG. 4 illustrates the "sample" type of trend display as does FIG. 1. In the sample type of display, the measurement data is sampled at the end of each trend interval. The resulting value is rounded to the nearest pixel, as required by the resolution of the available display screen. The vertical location of the activated pixel will depend upon the range in use, which is that of the largest value in the buffer.

FIG. 5 also is an enlarged illustration of a portion of a trend display, here illustrating the high-low type of trend display. Sampling data at the trend interval, for display as in FIG. 4, may not be sufficiently representative of the data throughout the interval for some applications. Here, the high and low values detected during each trend interval are graphically represented. For example, referring to column 60 in FIG. 5, activated pixel 62 represents the maximum value seen during the corresponding trend interval. In the same column, the bottom pixel 64 represents the lowest or minimum value seen during that same trend interval. Intermediate pixels 62 and 64 preferably are turned on as well to readily impart to the user a variability of the measurement data during that interval. In a subsequent trend interval corresponding to column 66 of the display, the data apparently was more stable. Only pixel 68 is turned on in this column, indicating that both the minimum and maximum values were the same within the limited resolution of the display. Trend display as described may be used for graphic display of various types of measurement data, including voltage, current, impedance and frequency.

FIG. 8 is an enlarged view of a portion of a trend display waveform illustrating the average-type of trend display. In this display, each column of pixels, for example column 240, indicates an average value of the measurements taken during the corresponding trend interval by activating a selected pixel. The average value is rounded to the nearest pixel, as required by the resolution of the available display screen. The vertical location of the activated pixel will depend upon the range in use, which again is that of the largest value in the buffer.

### II. DISCONTINUITY TREND DISPLAY--"GLITCH CAPTURE"

A fourth type of trend display; more specifically, an additional feature available in combination with any of the three primary types of trend displays, is a "glitch capture" or discontinuity option. In the currently preferred embodiment, this option is available only when the instrument is measuring ohms. Glitch capture is not shown in FIGs. 1 and 2 since the instrument mode illustrated there is measuring volts AC.

The discontinuity trend or "glitch capture' feature provides for capturing and graphically displaying discontinuities in trend data. More specifically, this feature detects changes in continuity at the input terminals. It can detect a fast discontinuity, that is a transition from open to short circuit or conversely, from a short to open circuit, of a duration on the order of a few microseconds. On the other hand, the change need not necessarily be particularly fast. Any transition between open and short is considered a discontinuity. This feature is particularly useful, for example, in connection with vibration testing of circuit boards. A board might be subjected to a vibration test for minutes or even hours. The test instrument can be set up in the trend display mode for the desired test interval with glitch capture enabled. During that time, none, a few, or any number of discontinuities might occur. The glitch capture feature essentially records those discontinuities and presents them to the user graphically as described above. This frees the user from having to constantly monitor the instrument for an indication of a discontinuity. Moreover, it provides an indication of when a discontinuity occurs (although multiple discontinuities within a single trend interval will be indicated only by a single icon). The discontinuity display feature can be used in connection with any of the trend display modes, samples, average or high-low.

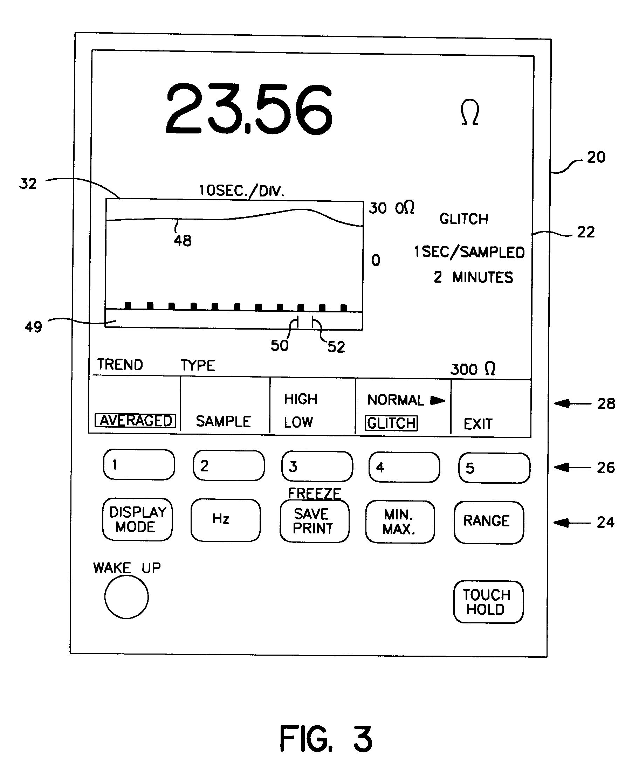

FIG. 3 illustrates the front panel 20 of the test instrument as described previously. The trend display mode again is selected, and the instrument is displaying the "trend type" submenu. The submenu is the same as described with reference to FIG. 2, except that a "glitch" option is now available as indicated over soft key (4). It may be observed that the instrument is set to measure impedance as shown in the primary numeric display near the top of display 22, where the value 23.56 ohms is indicated. Near the lower right portion of the display 22, it may be observed that the instrument is set to the 300-ohm range.

In the "glitch capture" mode of operation, the graphic display window 32 is arranged somewhat differently than before. The zero-ohms level is located approximately at the center of the vertical dimension of the graphic window, as indicated along the right side. Thus, the waveform 48 is constrained to the upper part of the graphic display window. A graticule 46 is provided as described previously to indicate periods of time, but here the graticule is positioned spaced part from the bottom of the graphic window 32. The remaining lower area 49 of the graphic window is reserved for "glitch marks" or icons, for example icons 50 and 52. These short, vertical lines indicate by their horizontal location the time at which one or more discontinuities occurred relative to the start of the test interval. For example, based on the illustrated trend interval of one second, icon 50 indicates that a discontinuity occurred at approximately 89 seconds after the test interval began. Similarly, icon 52 indicates a discontinuity occurred within the trend interval at approximately 95 seconds after the test interval began. A test interval begins when the type of trend display is selected, and it may be restarted by use of a soft key (5) as illustrated in FIG. 1.

### III. HARDWARE DESCRIPTION

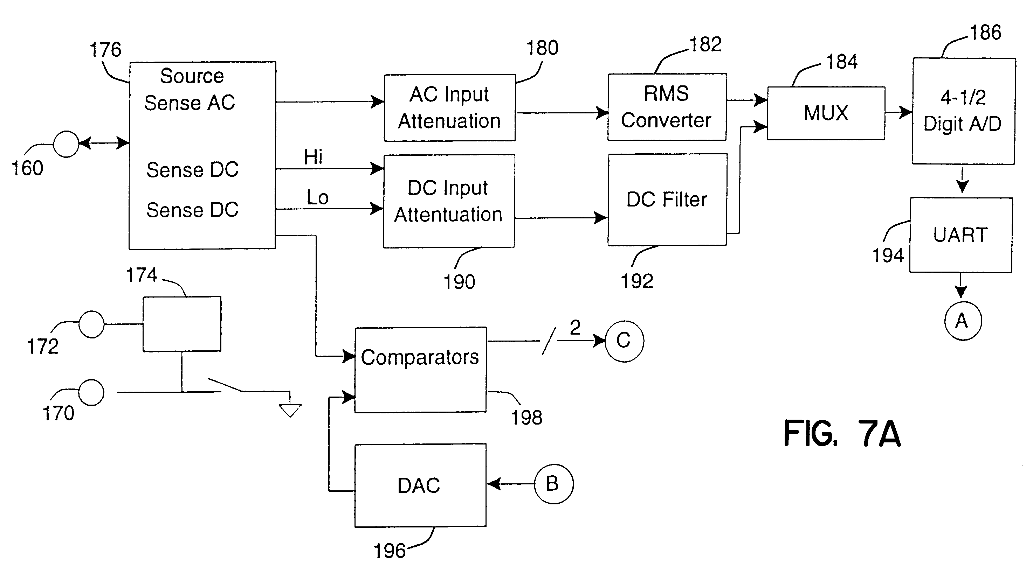

Figures 7A-7B together form a simplified block diagram of a new test instrument according to the present invention. The instrument and its operation is similar to a digital multimeter with respect to basic measurement or data acquisition features. Thus, it includes measurement circuitry for acquiring measurement data at an input terminal. Such conventional aspects of the system will be described only briefly as necessary to understanding the invention.

Referring to FIG. 7A, the "front end" section of the test instrument includes a pair of terminals 160, 170 for coupling a device under test (not shown) to the instrument via appropriate test leads or probes, as is conventional. For example, to measure AC or DC voltage, one lead is connected to a selected circuit node or DUT and a second lead is connected between terminal 170 and circuit ground or the opposite side of the DUT.

For AC measurements, the input signal originating at terminal 160 is routed through protection circuit 176 to an AC input attenuation circuit 180. The output of attenuation circuit 180 is coupled through an RMS converter 182 into the multiplexer 184. During AC meter operations, multiplexer 184 couples the RMS AC signal to the A/D converter 186. For current measurements, one or more additional terminals, e.g. terminal 172 (rather than the common terminal 170), is used for connecting the second lead to current switching circuitry 174. Further description of input attenuation and of meter operations is omitted as such is unnecessary to understanding the present invention.

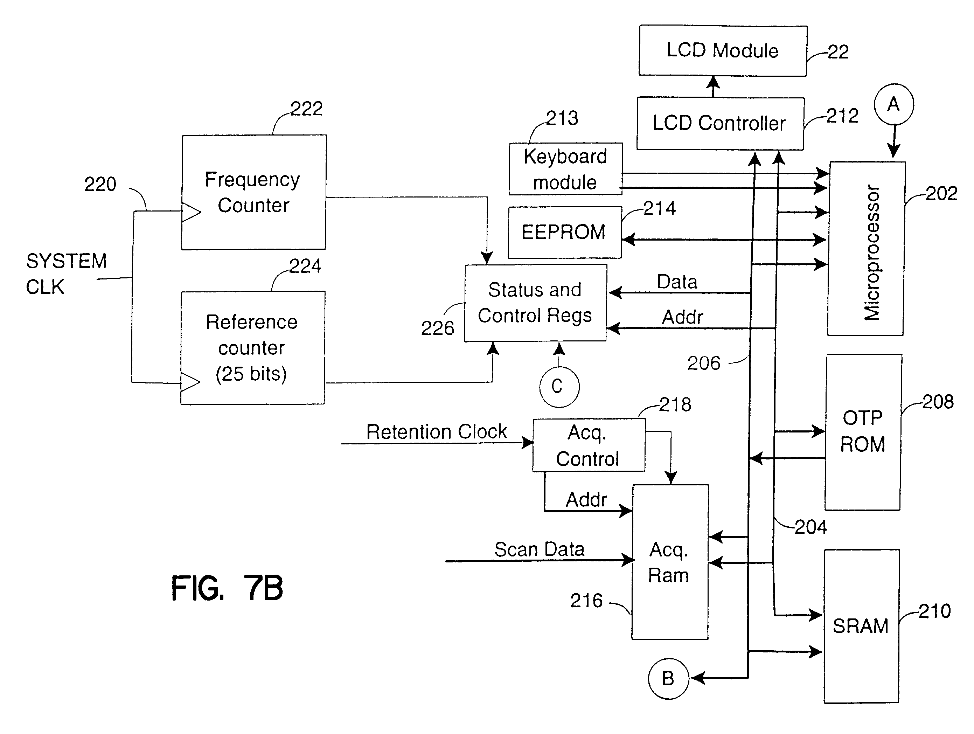

For DC voltage measurement, the input voltage presented at terminal 160 passes through a protection circuitry 176 (via either a high voltage or low voltage path) to a DC input attenuation circuit 190. When the instrument is set to operate as a DC voltage meter, the attenuated DC input signal passes through a DC filter 192 and a multiplexer 184 to an analog-to-digital converter A/D 186 for conversion into digital form. The resulting digital values are shipped via UART 194 to a microprocessor 202 shown on FIG. 7B.

Referring now to FIG. 7B, overall operation of the test instrument is managed under control of suitable software stored in OTP (one time programmable) ROM 208 or other nonvolatile memory and executed by microprocessor 202. The microprocessor is coupled to an address bus 204 and to a data bus 206. Keyboard module 213 interfaces to the keyboard controls in the front panel. An acquisition memory RAM 216 also is coupled to the address and data buses. The acquisition RAM is used for temporary storage of test scan data in operating modes not pertinent here, under control of data acquisition control circuitry 219, clocked by a retention clock signal. Selected data stored in the acquisition RAM may be transferred over data bus 206 to a system memory SRAM 210.

The address and data buses also are coupled to a status and control registers 226. EEPROM 214 is used for storing setup data, calibration data, user-stored data and parameters to be read on power-up. Software is stored in ROM 208 as noted. The common address and data buses 204, 206 also are coupled to a LCD (liquid crystal display) controller 212 for displaying data stored in the SRAM on an LCD module 22 described next. The LCD module provides the display 22 which is illustrated in use in FIGS. 1-3.

A wide variety of pixel-addressable display apparatus may be used for the purposes described. In a presently preferred embodiment, the display module comprises a liquid-crystal display (LCD) device, a variety of which are commercially available. LCD displays have the advantages of ruggedness, low cost and low power requirements versus other display technologies. A LCD suitable for the present application may be transflective or reflective and optionally may be backlit. In one commercial embodiment of the invention in a portable test instrument, an LCD module 22 has a total of 200 pixels (vertical) by 240 pixels (horizontal). In use, a portion of the display, e.g. measuring 64 pixels (vertical) by 120 pixels (horizontal) is used as a graphic display window for display of trend data as described above with reference to FIGS. 1-5. Other types and sizes of pixel-addressable display apparatus can be used for trend display and should be considered equivalents to the embodiment illustrated herein.

A system clock, e.g. a 19.2 MHz crystal-based oscillator (not shown), is applied at node 220 to clock a frequency counter 222. The frequency counter is used to provide frequency information about a test signal. The resulting count is provided to the status and control registers 226. The system clock also clocks a reference counter 224. The reference counter provides a known quantity over a predetermined time interval which can be used for calculating an input signal frequency from the value provided by counter 222. Frequency measurement data can be displayed using the trend display features described herein. Frequency counter values are available to the software for microprocessor manipulation via registers 226 as illustrated. This counter hardware can also be used for discontinuity trend display as follows.

For glitch capture, a pair of values are provided by the software to establish continuity thresholds. Two threshold values are used to provide hysteresis. They are in a range of approximately 2 to 25 Ω, for example, in the 300 Ω range. The threshold values may be selected depending upon the current range setting. Appropriate threshold values are stored in ROM 208 for lookup. The selected pair of threshold values, stored in digital form, are input to a digital to analog converter DAC 196 at node "B" as shown in FIG. 7A. The resulting pair of DC analog voltage levels are provided to a pair of analog comparators, respectively, indicated together as comparators 198. The lower threshold value is applied to a first input of one of the comparators (not shown) for detecting a high to low impedance transition. Conversely, the higher value is applied to a first input of the other comparator (not shown) to detect a low to high impedance transition. Each comparator receives a test input signal at its second input from terminal 160 via input protection circuit 176 during ohms measurement operations. The comparator output signals (2 "signal bits") are communicated through the UART 194 for examination by the software as described below. Alternatively, the comparator signal bits could be counted in counter 222 if it is not in use at the time for frequency counting.

### IV. OPERATION

To begin, it is assumed that the user has selected a desired trend interval as described above. In addition, the user has selected a trend *type* through the submenu. The glitch capture feature can be selected. These selections are stored, e.g. in SRAM 210, so they are available to the system software.

### Sampled Trend Data

When the user has selected trend display mode, and further has selected the *sampled* type of trend display, measurement data is sampled and stored at the end of each trend interval. Assuming that frequency measurement is not selected, measurement data are acquired as described above from the A/D converter 186, and transmitted via the UART to the microprocessor. These are referred to as "minor cycle" or "minor counts" data, updated every 25 msec (the minor cycle period). Smoothed minor counts data are stored periodically in acquisition RAM 216. At the end of each trend interval, the microprocessor stores the most recent smoothed values into SRAM 210. The end of the trend interval is based on a 10 µsec software clock which is checked by the software periodically. The SRAM is addressed by the software as a circular buffer.

Display of the trend data operates asynchronously in the sense that its timing is independent of the data acquisition timing just described. Display software periodically acquires data from the circular buffer. Each "display cycle" "unwraps" a next record from the buffer, scales the data (i.e. normalizes it to a single range determined by the largest value in the circular buffer), and then selects and activates selected pixels in the display. (The stored data also includes range data for each measurement datum.) The scaled value for each trend interval is indicated in a corresponding column of the graphic display window by activating (turning ON) a corresponding pixel in the display. Moreover, the graphical display "shifts" to the left on each display cycle, so that new data enters from the right, the most recent data always being visible. To provide this feature, effectively each record in the buffer is re-selected and re-displayed at each display cycle.

### Average Trend Data

When the user has selected the *average* type of trend display, minor cycle measurement data is averaged over each trend interval. More specifically, each minor cycle reading is added to a selected register based on its range. Additionally, a counter or register is incremented for counting the number of minor cycles measured. When a trend interval is completed (as may be signalled to the software by an interrupt), the accumulated values are calibrated, normalized, summed, and then divided by the number of minor cycles to determine an average value. The result is stored in the circular buffer, along with range data, as before. Then the sum register and the minor cycle counting register are reset to begin accumulating data for the next trend interval. A display software module controls accessing the circular buffer for transmitting the data to the display controller 212. Note that after an elapsed time greater than the test interval, new data overwrites the previously displayed data, so that the graphical trend display waveform seemingly moves across the display window, with new data entering from the right side of the window. In this way, the display always shows the most recent test interval. This moving window is provided by the software controlling pointers into the circular buffer 210 for continuously writing and reading data as appropriate.

### High/Low Trend Data

When the user has selected the *High/Low* type of trend display, minor cycle measurement data is examined over each trend interval, and the highest and lowest values for each interval are detected, stored and displayed by activating a corresponding pair of pixels on the display module. More specifically, each minor cycle reading is compared by the software to the previous high and low readings. If the new reading is greater than the previous high reading, or if the new reading is lower than the previous low reading, the new reading replaces the previous high or low value, respectively, as further described below in the software description. The registers used for storing high and low values are reset at the beginning of each trend interval.

### Frequency Trend Display

For frequency measurements, frequency counters 222,224 are used to provide frequency data as described previously. The primary numeric display on the instrument (see description of FIG. 1) can be set to display frequency, period or duty cycle. If trend display mode is selected, the parameter shown in the primary numeric display also is used for the trend display.

### V. SOFTWARE DESCRIPTION

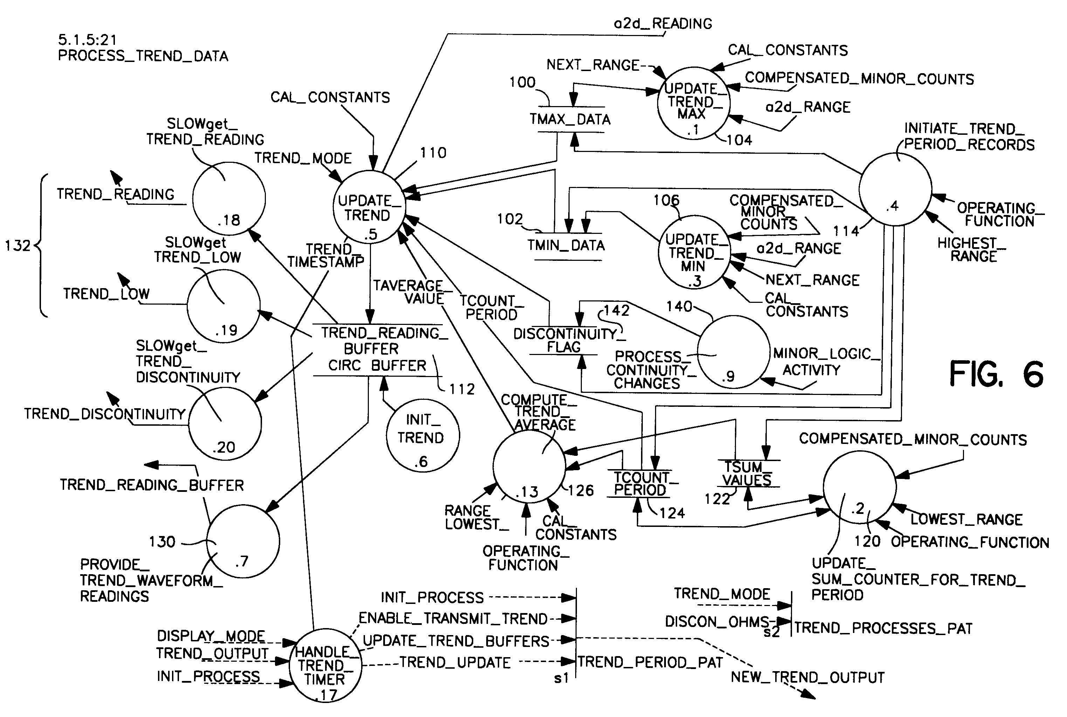

FIG. 6 is a data flow diagram describing operation of the system software as pertinent to trend display. The software can be stored in OTP ROM 208 (FIG. 7B) for execution by the microprocessor 202 and related registers described above. In the data flow diagram of FIG. 6, each circle represents a process which uses or manipulates data, while the lines indicate data flows. The process names are generally descriptive of their functions. The arrowhead at the end of each data flow line indicates the direction of data flow. Data is not necessarily moved by a data flow; it may simply be read as needed. Control flows are indicated by dashed lines in the diagram. Process activation tables are shown by heavy vertical lines. Each pair of parallel horizontal lines, for example "tmax_data" 100, indicates a data store, i.e. a set of data which is stable unless and until it is modified by the software; for example, data stored in a memory. These data stores can be implemented in hardware registers or software buffers, and are referred to as registers as appropriate in the following description.

Central to the data flow diagram is a circular data buffer 112, the "trend_reading_buffer" which, under software control, is implemented in the SRAM 210 (FIG. 7B). This buffer holds pointers to the first and last ("head" and "tail") records plus the actual trend data. If the trend mode is "sampled", the "a2d_reading" is stored with the current "a2d_range". If the trend mode is "trend_averaged" the running trend total data has each range total scaled and the average computed. This result and the "a2d_range" are stored in the buffer for display. If the trend type is high/low or discontinuity together with high/low, the minimum data and maximum data are stored along with their respective ranges, as further explained below. The data flow diagram of FIG. 6 illustrates operation of the instrument to assemble data in the trend reading buffer as follows.

### Sampled Trend Display

At the end of each trend interval, process 110 "update_trend" writes the current reading into the circular trend reading buffer 112. More specifically, the present a2d_reading is stored together with the present range information "a2d_range". Memory address pointers are updated in preparation for the next trend interval. Control for processing each trend interval originates with a process activation table 113. Display of acquired trend data is described below.

### Average Trend Display

Referring to the lower right corner of FIG.6, a new measurement or reading "compensated_minor_counts" arrives, and process 120 is activated to add that current reading to the sum value of registers indicated as "tsum_values" 122. Process 120 also increments a value "tcount_period" in register 124 to track the number of minor cycles measured. When the selected trend interval completes, process 110 "update_trend" is activated and, because the instrument is in the average mode, control proceeds to process 126 called "compute_trend_average". Process 126 accesses the sum values in register 122, calibrates, normalizes and sums them, and then divides the sum by the number of cycles stored in register 124. The resulting average value is stored in the "trend_reading_buffer" 112 by process 110. Once that is done, process 114 "initiate_trend_period_records" resets the registers 122 and 124 to begin the next trend interval.

### High/Low Trend Display

The high/low type of trend operation is illustrated in the data flow diagram as follows. Compensated minor counts are accessed by "update_trend-max" process 104 which updates the trend maximum or high value stored in a register "tmax_data" 100. Similarly, the compensated_minor_counts for each minor cycle are accessed by an "update_trend_min" process 106 which updates a minimum or low value stored in a register "tmin_data" 102. More specifically, the update maximum and minimum value processes 104, 106 each compares the current measurement value to data previously stored in 100,102, respectively, and replaces the stored value with the new value if it is higher or lower, respectively. It may be observed that current measurement range data indicated as "a2d_range" is accessed by processes 104,106 so that the proper range is taken into account in determining and storing minimum and maximum values. At the end of each trend interval, the current values stored in registers 100,102 representing the high and low values for that interval are stored in the trend reading buffer 112 by the trend update process 110. The corresponding range values are stored in buffer 112 as well. Registers 100,102 are then reset by a process 114 to begin the next trend interval.

### Discontinuity Trend Display

Referring to the bottom of the data flow diagram of FIG. 6, control flows indicating the trend mode and ohms function and glitch capture are input to a process activation table 138. The process activation table controls the following sequence of events. A process 140 "process_continuity_changes" receives "minor_logic_activity" data, which corresponds to the two signal bits that originate in the analog comparators 198 of FIG. 7A to signal discontinuities. Process 140 updates a "discontinuity_flag" register 142, which stores a discontinuity flag, to indicate whether a glitch was detected during the current trend interval. (Additional glitches within the same trend interval merely repeat setting the flag 142. In an alternative embodiment, the flag can be a counter so that the actual number of glitches during an interval might be accumulated and stored.) At the end of the trend interval, the "update_trend" process 110 occurs, and if the glitch capture option is enabled, process 110 accesses the "discontinuity_flag" 142 and stores that information in the "trend_reading_buffer" 112 along with the other data that it has processed for the just completed trend interval. Process 114 zeroes the high/low and average data and also resets the "discontinuity_flag" 142 so that the system is ready for the next trend interval. Display of the discontinuity bits is described below.

### Display Process

Process 130 supports graphic display of accumulated trend data. When it is time for the display to show the trend waveform, data stored in circular buffer 112 must be unwrapped and scaled. Process 130 accesses that circular buffer and begins the unwrapping and scaling process. Each record in the buffer is displayed graphically in a corresponding column of the display as noted above.

If glitch capture is enabled, the software will put up an additional window to display this discontinuity bit below the trend waveform, as described in the user interface section. The discontinuity bit is displayed by turning on one or more pixels, preferably approximately three pixels in the corresponding trend interval column so as to form a short, vertical bar. This bar is aligned with the high/low, average or sampled data in the same column of the display. Accordingly, the discontinuity bits are stored in the trend reading buffer aligned to the same index as the other trend data.

If the optional RS232 output feature is enabled, it is so indicated by the "trend_output" control flow shown on the bottom of the diagram. That control causes a "handle_trend_timer" process 134 to access a last value stored in buffer 112 and transmit it to an RS232 port (after appropriate formatting). Two processes 132A and 132B are used to access trend data in the trend reading buffer in preparation for transmitting it over the RS232 port. Two processes are provided because two values -- high and low -- must be read from the buffer during the high/low type of operation. This operation is independent of the graphical display on the instrument.

Having illustrated and described the principles of my invention in a preferred embodiment thereof, it should be readily apparent to those skilled in the art that the invention can be modified in arrangement and detail without departing from such principles. For example, implementation of particular functions in hardware vs. software, or vice versa, or some combination of the two that differs from the illustrated embodiment is merely an engineering design choice and shall be deemed equivalents. I claim all modifications coming within the spirit and scope of the accompanying claims.

## Claims

1. In an electronic test instrument having measurement circuitry for acquiring electrical measurement data at an input terminal, a method of displaying the measurement data to a user comprising the steps of:
providing a pixel-addressable display module in the test instrument;
selecting a trend interval;
periodically measuring a selected electrical parameter at the input terminal so as to acquire measurement data, the measurement data comprising a series of measurement readings and including at least one reading per trend interval;
detecting an end of each trend interval; and
forming a trend display on the display module, the trend display comprising a series of columns of pixels, each column of pixels corresponding to a respective one of the trend intervals, and each column of pixels having one or more pixels activated so as to represent measurement data acquired during the corresponding trend interval, thereby displaying the measurement data in a simplified, graphical format.

2. A method according to claim 1 and further comprising the steps of:
forming a graphic display window on the display module;
forming the trend display within the graphic display window; and
displaying numeric measurement information on the display module adjacent the graphic display window.

3. A method according to claim 1 wherein the trend interval is selected within a range of approximately one second to fifteen minutes and further including dividing the trend interval over a width of the display determined by the number of columns of pixels.

4. A method according to claim 1 wherein the step of selecting a trend interval includes providing a predetermined series of choices, the choices including trend intervals within a range of approximately 1 second to 15 minutes, each interval corresponding to an integer number of columns.

5. A method according to claim 1 further comprising providing one or multiple soft keys on the test instrument and arranging the soft keys for selecting among the trend interval choices.

6. A method according to claim 1 further comprising:
sampling the measurement data at the end of each trend interval;
for each trend interval, selecting a pixel in the corresponding column of the display module, the selected pixel having a vertical location indicative of the value of the measurement reading at the end of the corresponding trend interval; and
for each column in the display module, activating the corresponding selected pixel, thereby forming a sampled trend display on the test instrument.

7. A method according to claim 1 further comprising:
sampling the measurement data periodically during a trend interval;
averaging the sampled measurement data to determine an average value for the trend interval;
storing the average value for the trend interval; and
repeating said sampling,averaging and storing steps over a plurality of trend interval data acquisition cycles to form a series of stored average values; and wherein
said forming a trend display includes, for each stored average value, scaling the stored value, and then selecting and activating a pixel in the corresponding column of the display module, the selected pixel having a vertical location indicative of the stored average value of the corresponding trend interval; thereby forming an average trend display on the test instrument.

8. A method according to claim 1 further comprising:
sampling the measurement data periodically during a trend interval;
determining a high value of the sampled measurement data during the trend interval;
determining a low value of the sampled measurement data during the trend interval;
at an conclusion of the trend interval, storing the high value for the trend interval; and
at an conclusion of the trend interval, storing the low value for the trend interval;
repeating said sampling, determining a high value, determining a low value, storing the high value, and storing the low value steps over a plurality of trend interval data acquisition cycles, so as to form a series of stored high/low value pairs; and wherein said forming a trend display includes, for each stored high/low value pair;
selecting a first pixel in the corresponding column of the display module, the first selected pixel having a vertical location indicative of the stored high value for the corresponding trend interval;
selecting a second pixel in the corresponding column of the display module, the second selected pixel having a vertical location indicative of the stored low value for the corresponding trend interval;
activating the first and second selected pixels and intermediate pixels; and
repeating said selecting a first pixel, selecting a second pixel, and activating steps over a plurality of trend intervals, thereby forming a high/low trend display on the test instrument.

9. A method according to claim 1 further comprising:
detecting a continuity change at the input terminal;
responsive to said detection of a continuity change, updating continuity change data; and
at an conclusion of the trend interval, storing the updated continuity change data in association with the said trend interval.

10. A method according to claim 9 further comprising:
designating a predetermined area on the display adjacent the columns of pixels for displaying a discontinuity icon; and
for each trend interval during which a change in continuity was detected and stored, activating one or more pixels within said predetermined area of the display and adjacent the corresponding column of pixels, so as to form a discontinuity icon that graphically identifies by its location the trend interval during which the change in continuity was detected and stored.

11. A method according to claim 9 wherein said detecting a continuity change includes:
providing high and low predetermined threshold values;
measuring an impedance at the input terminal so as to form a corresponding value;
comparing the said value to the low and high threshold values;
detecting and indicating a discontinuity whenever the said value transitions from a value below the low threshold value to a value above the low threshold value;
detecting and indicating a discontinuity whenever the said value transitions from a value above the high threshold value to a value below the high threshold value; and
updating the said continuity change data responsive to each of said indications.

12. A portable test instrument comprising:
input means for coupling a device under test to the instrument;
measurement means coupled to the input means for measuring one at a time of a plurality of user-selectable electrical parameters, the selectable parameters including at least voltage and current, to form measurement values;
data acquisition means coupled to the measurement means for acquiring a series of said measurement values over a predetermined test interval;
a pixel-addressable display means coupled to the data acquisition means; and
means for controlling the display means so as to present a graphical representation of the series of measurement values acquired over the test interval.

13. A portable test instrument according to claim 12 wherein:
the test interval comprises a plurality of trend intervals;
the display means includes a series of columns of pixels; and
the controlling means is arranged to activate each column of pixels responsive to a respective portion of the measurement values acquired during a corresponding one of the trend intervals.

14. A portable test instrument according to claim 12 wherein the control means includes means for updating the display means so that the graphical representation of measurement values forms a moving waveform responsive to changes in the acquired measurement values over time.

15. A portable test instrument according to claim 12 further comprising user-selectable means for selecting a desired test interval, thereby determining a length of time graphically represented on the display means.

16. A portable test instrument according to claim 12 wherein:
the test interval comprises a plurality of trend intervals;
the display means includes a series of columns of pixels;
the data acquisition means is arranged so that each one of the series of measurement values is acquired at a conclusion of a respective one of the trend intervals; and
the display control means is arranged to activate each column of pixels responsive to a corresponding one of the series of measurement values, whereby the graphical representation forms a sampled type of trend display.

17. A portable test instrument according to claim 12 wherein:
the test interval comprises a plurality of trend intervals;
the display means includes a series of columns of pixels;
the data acquisition means includes means for averaging measurement values acquired over each trend interval, so that each one of the series of measurement values comprises an average value over a respective one of the trend intervals; and
the display control means is arranged to activate each column of pixels responsive to a corresponding one of the series of measurement values, whereby the graphical representation forms an average type of trend display.

18. A portable test instrument according to claim 12 wherein:
the test interval comprises a plurality of trend intervals;
the display means includes a series of columns of pixels;
the data acquisition means includes means for determining a high value and a low value among the measurement data acquired over each trend interval, so that each one of the series of measurement values comprises a high value and a low value over a respective one of the trend intervals; and
the controlling means is arranged to activate each column of pixels responsive to a corresponding one of the series of measurement values, whereby the graphical representation forms a high/low type of trend display.

19. A portable test instrument according to claim 12 wherein the test interval comprises a plurality of trend intervals; and further comprising means for detecting a change in continuity at the input means and means for identifying to the user a trend interval during which the change in continuity was detected.

20. A portable test instrument according to claim 19 wherein:
the display means includes a series of columns of pixels;
the controlling means is arranged to activate each column of pixels responsive to a corresponding one of the series of measurement values, whereby the graphical representation forms a trend display in which each column of pixels corresponds to a respective one of the trend intervals; and
the means for identifying the trend interval during which the change in continuity was detected includes means for displaying a discontinuity icon on the display means adjacent the corresponding column of pixels.

21. A portable, preferably hand-held, test instrument operable automatically and repeatedly to take measurements and to produce a graphical display in response to those measurements, the display representing at least one of:
(a) a trend representing the manner in which measurements taken at predetermined intervals change with time;
(b) a trend representing the manner in which averages of a measurement over a predetermined interval change with time;
(c) a trend representing the manner in which the level of the highest (and/or lowest) value measured during a predetermined interval changes with time; and
(d) the times during the period in which the measurements are taken at which glitches occur.
